# FASCICULE DE BREVET EUROPEEN

(11) **EP 3 675 616 B1**
(45) Date de publication et mention de la délivrance du brevet: **13.09.2023**
(21) Numéro de dépôt: 19219616.0
(22) Date de dépôt: 24.12.2019
(51) Int. Cl.: H05K 7/20

(54) **SYSTÈME DE PROTECTION POUR UN COMPOSANT ÉLECTRONIQUE**
SCHUTZVORRICHTUNG FÜR EINE ELEKTRONISCHE KOMPONENTE
SYSTEM FOR PROTECTING AN ELECTRONIC COMPONENT

(30) Priorité: 26.12.2018 FR 1874095
(43) Date de publication de la demande: 01.07.2020
(73) Titulaire: Thales, 92400 Courbevoie (FR)
(72) Inventeur: GHERIB, Mehdi, 92622 GENNEVILLIERS CEDEX (FR); CALVET, Bruno, 92622 GENNEVILLIERS CEDEX (FR); GRIBOVALLE, David, 49309 CHOLET (FR); BRAGATO, Jérémy, 92622 GENNEVILLIERS CEDEX (FR); SERMET, Fabrice, 92622 GENNEVILLIERS CEDEX (FR)
(74) Mandataire: Lavoix

(56) Documents cités:
- EP-A2- 2 672 797
- DE-U1- 9 312 138
- US-A- 4 259 843
- US-A1- 2010 059 270
- US-A1- 2010 242 523

## Description

La présente invention se rapporte notamment à l'intégration de composants électroniques dans des équipements électroniques durcis.

Lors de la construction d'appareils électroniques complexes, tels que des systèmes de télécommunication, il est fréquent d'avoir recours à des composants électroniques standards achetés « sur étagère » (« commercial off-the-shelf components » en anglais) plutôt que de développer sur mesure des composants spécifiques.

Toutefois, pour certaines applications, en particulier dans les domaines militaire, aéronautique et industriel, les appareils électroniques ainsi assemblés doivent être en mesure de subir, lors de leur fonctionnement, des contraintes environnementales extrêmes qui vont bien au-delà des plages de fonctionnement nominales des composants électroniques standards achetés sur étagère.

Les équipements électroniques doivent ainsi être « durcis », c'est-à-dire qu'ils doivent être associés à des systèmes de protection, notamment pour présenter une étanchéité renforcée ainsi qu'une résistance accrue aux chocs mécaniques, aux perturbations électromagnétiques et aux températures extrêmes.

En particulier, pour refroidir les composants électroniques les plus sensibles, il est courant d'inclure dans ces appareils électroniques un groupe frigorifique, comportant généralement un compresseur et un circuit de fluide frigorigène. L'usage d'un tel groupe frigorifique engendre toutefois de nombreux inconvénients.

En particulier, la gestion des fluides frigorigènes impose de nombreuses contraintes opérationnelles, notamment en termes de maintenance ou d'incompatibilité avec certaines applications (températures de fonctionnement limitées, génération de bruit, risque d'incendie...).

Par ailleurs, ces groupes frigorifiques sont souvent encombrants et conduisent à des problèmes d'intégration et de construction des appareils électroniques, car ils ne peuvent pas être miniaturisés facilement.

US 4259843A décrit, par exemple, une enceinte monobloc séparée en deux compartiments isolés et refroidis par des pompes à chaleur et des échangeurs thermiques. Les pompes à chaleur sont contrôlées au moyen d'un circuit de commande situé dans un logement séparé.

EP-2 672-797-A2 décrit quant à lui un boitier de réception d'un équipement électronique, ce boitier comprenant une paroi intermédiaire, qui divise le boitier en deux compartiments et dans laquelle est ménagée une ouverture permettant le passage entre les deux compartiments. Un module Peltier est fixé sur un fond d'un des deux compartiments.

De surcroît, ces groupes frigorifiques nécessitent de subir des opérations de maintenance fréquentes, et peuvent subir des avaries plus ou moins graves, pendant lesquelles l'appareil électronique ne peut pas être utilisé.

Plus généralement, l'intégration des composants achetés « sur étagère » est fréquemment rendue compliquée par les problèmes d'obsolescence, qui font que ces composants peuvent être retirés du marché et devenir indisponibles bien avant la fin de vie de l'appareil électronique. Il est alors nécessaire d'avoir recours à des composants de remplacement.

Le plus souvent, les composants de remplacement présentent des dimensions et des formes différentes de celles des composants qu'ils remplacent. L'intégration de ces nouveaux composants dans les appareils électroniques se trouve alors particulièrement compliquée, d'autant plus que la configuration du groupe frigorifique et des équipements connexes permettant le refroidissement est souvent étroitement adaptée à la forme et aux autres caractéristiques structurelles du composant électronique en question.

En d'autres termes, l'utilisation d'un nouveau composant peut nécessiter une modification, voire un redéveloppement complet du groupe frigorifique.

Il existe donc un besoin pour intégrer des composants électroniques de façon durcie à l'intérieur d'un appareil électronique tout en remédiant aux inconvénients précités.

À cet effet, un aspect de l'invention concerne un système de protection selon la revendication 1.

Grâce à l'invention, le système assure, grâce au boîtier, une protection mécanique d'un ou plusieurs composants électroniques ainsi qu'un refroidissement du ou des composants électroniques grâce au dispositif à base de modules Peltier, ce qui permet de s'affranchir des contraintes propres aux groupes frigorifiques classiques.

Selon des aspects avantageux mais non obligatoires, un tel système de protection peut incorporer une ou plusieurs des caractéristiques suivantes, prises isolément ou suivant toute combinaison techniquement admissible :
- Les premier et deuxième compartiments sont isolés physiquement et thermiquement l'un de l'autre par une paroi de séparation.
- Le dispositif de refroidissement comporte également un radiateur externe connecté aux modules Peltier.
- Le système de protection comporte un étage additionnel connecté au deuxième compartiment et qui délimite un volume de réception du radiateur extérieur, l'étage additionnel comportant au moins un ventilateur pour évacuer la chaleur dégagée par le radiateur externe vers l'extérieur du boîtier.
- Les modules Peltier sont directement montés sur une feuille d'un matériau thermiquement conducteur, notamment une feuille de graphite, placée sur le radiateur externe.
- Les parois intérieures de la deuxième enceinte sont au moins en partie recouvertes d'un matériau thermiquement isolant.
- Le dispositif de refroidissement comporte un radiateur interne monté sur les modules Peltier et disposé à l'intérieur de la deuxième enceinte.
- Au moins un composant électronique est installé à l'intérieur du deuxième compartiment.
- Le premier compartiment comporte un dispositif de refroidissement auxiliaire incluant un conduit de ventilation dans lequel est placé au moins un ventilateur, le conduit de ventilation étant intégré à l'intérieur du premier compartiment et longeant la première enceinte.
- Le système de protection comporte au moins un capteur connecté au circuit de commande pour mesurer une ou plusieurs grandeurs environnementales à l'intérieur de la deuxième enceinte, tels qu'un ou plusieurs capteurs de température et/ou d'humidité et/ou de pression.
- Le circuit de commande est également configuré pour piloter un ou plusieurs ventilateurs pour assurer la régulation de température.

L'invention sera mieux comprise et d'autres avantages de celle-ci apparaîtront plus clairement à la lumière de la description qui va suivre d'un mode de réalisation d'un système de protection pour un composant électronique, donnée uniquement à titre d'exemple et faite en référence aux dessins annexés, dans lesquels :
[Fig 1] la figure 1 illustre, selon une vue en perspective, un système de protection pour un composant électronique selon un mode de réalisation de l'invention ;
[Fig 2] la figure 2 illustre, selon une vue éclatée, le système de protection de la figure 1 ;
[Fig 3] la figure 3 illustre, de façon simplifiée et selon une vue en coupe, un compartiment du système de protection des figures 1 et 2.

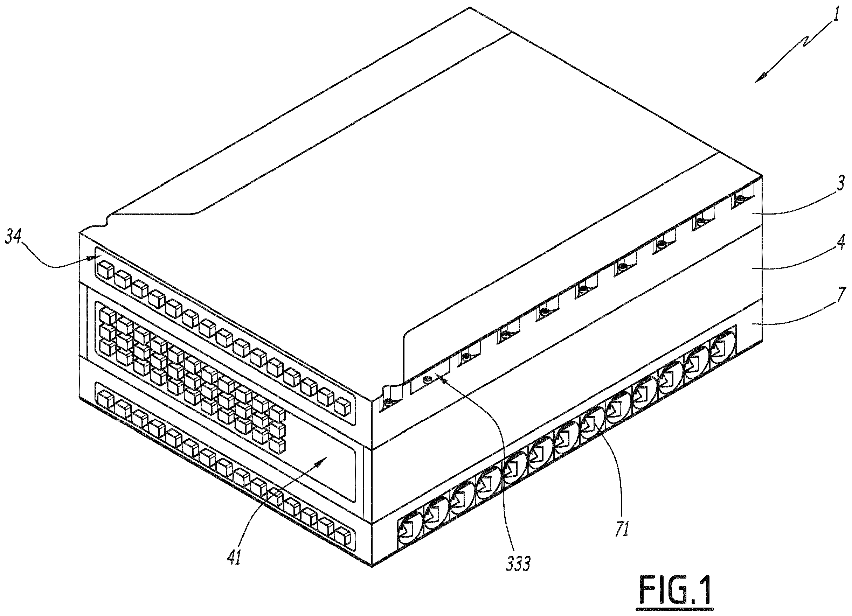

Sur la figure 1 est représenté un système de protection 2 pour un composant électronique.

Le système de protection 2 est adapté pour protéger un ou plusieurs composants électroniques 5 afin de former un appareil électronique « durci » présentant une résistance accrue à des conditions environnementales, notamment pour présenter une étanchéité renforcée ainsi qu'une résistance accrue aux chocs mécaniques, aux perturbations électromagnétiques et aux températures extrêmes.

Un tel système de protection 2 est particulièrement avantageux lorsque l'appareil électrique formé par l'association de composants électroniques 5 installés dans le système de protection 2 est déployé en extérieur dans des environnements extrêmes (déserts, milieux tropicaux, haute montagne...), et/ou lorsque l'appareil électronique est destiné à être monté à bord d'un véhicule, par exemple un véhicule militaire ou un aéronef.

À titre d'exemple illustratif et non nécessairement limitatif, les composants électroniques 5 peuvent se présenter sous la forme de cartes électroniques ou d'équipements unitaires préassemblés (comme une unité d'alimentation électrique, un dispositif de stockage d'information, etc.).

Selon des exemples, au moins une partie des composants électroniques 5 sont des composants achetés sur étagère (« commercial off-the-shelf » en anglais).

L'appareil électronique destiné à être formé à partir des composants électroniques 5 est ici un appareil de traitement de données tel qu'un ordinateur, ou un appareil de mesure, ou un équipement de télécommunications, par exemple un équipement de routage.

Pour assurer une protection mécanique, le système de protection 2 comporte un boîtier, de préférence réalisé en un matériau rigide et résistant aux chocs, aux chutes et aux impacts.

Par exemple, le boîtier est en métal, ou en polymère thermoformé, ou en matériau composite, ou toute combinaison de ces matériaux.

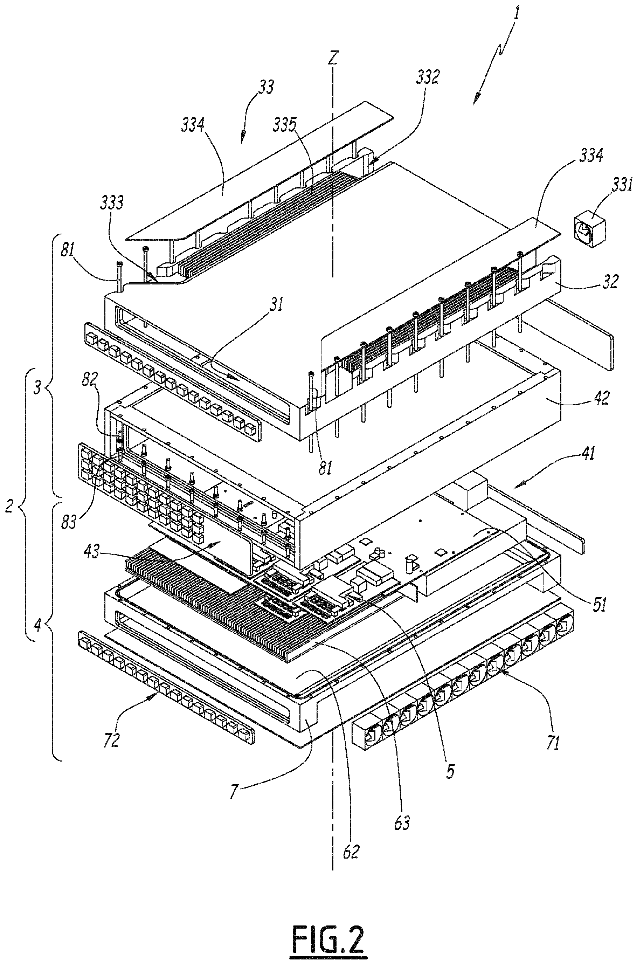

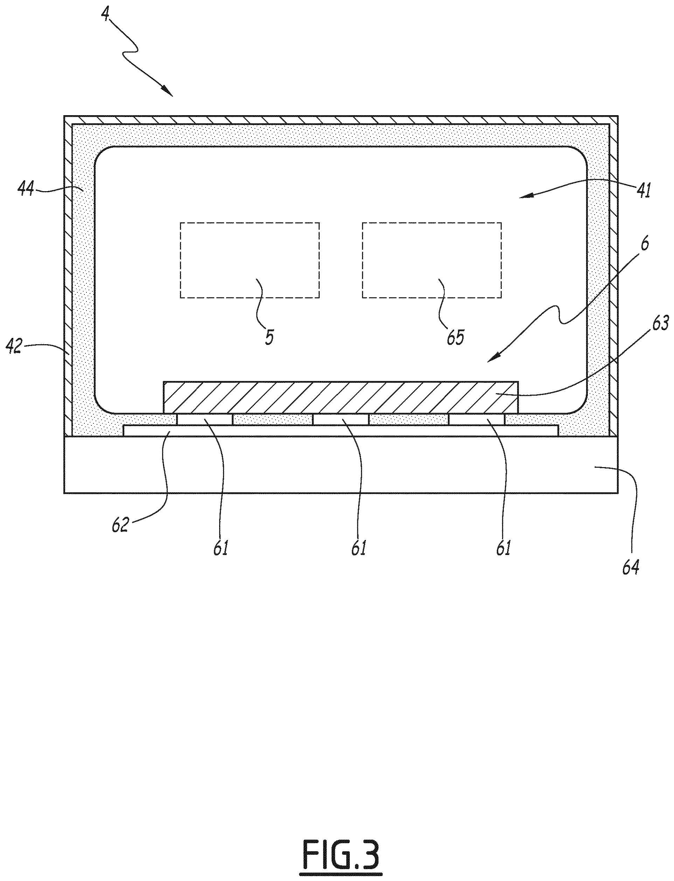

Le système de protection 2 est représenté plus en détail sur les figures 2 et 3.

Le boîtier comporte un premier compartiment 3 et un deuxième compartiment 4 qui délimitent respectivement une première enceinte fermée 31 et une deuxième enceinte fermée 41.

Dans l'exemple illustré, le boîtier présente une forme de pavé à base rectangulaire. Les compartiments 3 et 4 présentent une forme analogue avec une base rectangulaire de dimensions similaires ou identiques.

Par exemple, les compartiments 3 et 4 comportent des parois latérales 32, 42, des parois supérieure et inférieure et des parois avant et arrière fixées entre elles, par exemple par soudage, qui ferment les enceintes 31 et 41 par rapport à l'extérieur du boîtier.

De préférence, les compartiments 3 et 4 sont isolés physiquement et thermiquement l'un de l'autre par une paroi de séparation.

Les compartiments 3 et 4 sont ici superposés l'un au-dessus de l'autre le long d'un axe vertical Z.

De préférence, le premier compartiment 3 est détachable du deuxième compartiment 4.

En configuration assemblée du système 2, les compartiments 3 et 4 sont attachés l'un à l'autre et sont en contact direct l'un avec l'autre.

Dans l'exemple illustré, les premier et deuxième compartiments 3 et 4 sont attachés l'un à l'autre, de façon réversible, au moyen de dispositifs de fixation tels que des vis 81 et 82 ou des boulons.

Par exemple, des vis 81 sont disposées le long de bords latéraux des compartiments 3 et 4, et des vis 82 sont disposées le long des bords avant et arrière des compartiments 3 et 4, dans des orifices de réception appropriés.

Selon certains exemples, les parois avant et arrière peuvent être pourvues d'ouvertures en forme de baie ou de fente.

De préférence, les ouvertures en face avant et arrière sont alors fermées par des plaques 34, 43 qui peuvent porter des connecteurs électriques et/ou des interfaces de communication raccordés aux composants électroniques logés dans l'enceinte correspondante (organe de commande, écran d'affichage, témoin lumineux...).

Chaque enceinte 31 et 41 forme un volume de réception propre à accueillir un ou plusieurs composants électroniques.

Par exemple, la première enceinte 31 reçoit un ou plusieurs composants électroniques, notamment des composants électroniques ne nécessitant pas un refroidissement lors de leur fonctionnement.

La deuxième enceinte 32 comporte un ou plusieurs composants électroniques sensibles qui nécessitent un refroidissement et/ou une régulation de la température ambiante.

Dans l'exemple illustré, plusieurs composants électroniques 5 sont installés à l'intérieur de la deuxième enceinte 41.

Par exemple, ces composants électroniques 5 comportent une carte électronique principale 51 sur laquelle sont connectées des cartes électroniques additionnelles.

Peuvent aussi être connectés un ou plusieurs blocs ou assemblages, tels qu'un bloc d'alimentation électrique, raccordés à l'une des cartes électroniques.

Par exemple, le deuxième compartiment comporte des moyens de fixation permettant de monter les composants électroniques 5 à l'intérieur de la deuxième enceinte 41.

De façon avantageuse, les parois 42 de la deuxième enceinte sont au moins en partie recouvertes d'un matériau thermiquement isolant 44.

En pratique, le matériau isolant 44 est disposé sur les faces internes des parois 42, à l'intérieur de la deuxième enceinte 41.

Le système de protection 2 comporte un dispositif de refroidissement 6 incluant au moins un module Peltier 61 fixé sur le fond de la deuxième enceinte 41.

Par « module Peltier », on désigne ici un module de refroidissement thermoélectrique à effet Peltier.

Par exemple, chaque module Peltier 61 comporte une cellule thermoélectrique de forme plane ou essentiellement plane, comprenant une face froide et une face chaude et à laquelle est connecté un circuit d'alimentation électrique.

Dans l'exemple illustré, le dispositif de refroidissement 6 comporte plusieurs modules Peltier 61, dont le nombre est par exemple supérieur à 2 ou à 6 et inférieur à 20.

Le dispositif de refroidissement 6 comporte également un radiateur externe 64 connecté aux modules Peltier 61, de préférence thermiquement connecté avec la face chaude des modules Peltier.

Le radiateur externe 64 est disposé à l'extérieur de la deuxième enceinte 41, de manière à évacuer la chaleur dégagée par les modules Peltier 41 lors de leur fonctionnement.

Par exemple, le radiateur externe 64 comporte une plaque métallique pourvue d'ailettes.

De préférence, le dispositif de refroidissement 6 comporte une feuille 62 d'un matériau thermiquement conducteur, notamment une feuille de graphite, sur laquelle sont montés les modules Peltier 61.

Plus précisément, les faces chaudes respectives des modules Peltier 61 sont en contact direct avec la feuille 62.

En d'autres termes, le radiateur externe 64 est indirectement connecté aux modules Peltier 61 par la feuille 62, celle-ci étant intercalée entre les modules Peltier 61 et le radiateur externe 64.

Ainsi, la connexion thermique entre le radiateur externe 64 et les faces chaudes des modules Peltier 61 est assurée par la feuille 62.

La feuille 62 permet d'assurer que la face chaude des modules Peltier 61 soit parfaitement en contact avec le radiateur externe 64, de sorte à assurer une bonne conductivité thermique entre la face chaude des modules Peltier 61 et le radiateur extérieur 64.

En pratique, la feuille 62 est disposée sur le fond de la deuxième enceinte 41.

Selon des modes de réalisation avantageux, le dispositif de refroidissement 6 comporte également un radiateur interne 63, placé à l'intérieur de la deuxième enceinte 41 et monté sur les faces froides des modules Peltier 61.

Le radiateur interne 63 permet ainsi d'assurer un refroidissement homogène de la deuxième enceinte 41.

Par exemple, le radiateur interne 63 comporte une plaque métallique pourvue d'ailettes.

Selon des modes de mise en oeuvre, le dispositif de refroidissement 6 comporte également au moins un ventilateur 65 installé à l'intérieur de la deuxième enceinte 41.

Par exemple, le ventilateur 65 contribue à assurer un refroidissement homogène de la deuxième enceinte 41 lorsque le dispositif de refroidissement 6 est en fonctionnement.

Selon des exemples, le dispositif de refroidissement 6 comporte au moins un circuit électronique de commande logé dans la première enceinte 31 et connecté aux modules Peltier 61 par l'intermédiaire d'une liaison filaire.

Par exemple, pour permettre le passage de la liaison filaire vers les modules Peltier 61 disposés à l'intérieur de la deuxième enceinte 41, la paroi séparant le premier compartiment du deuxième compartiment est pourvue d'un orifice traversant dans lequel est monté un connecteur électrique.

De préférence, le connecteur électrique comporte des moyens d'isolation thermique, tels qu'un joint, pour éviter de créer un point de fuite ou un pont thermique vers l'extérieur de la deuxième enceinte 41.

Le circuit de commande est notamment configuré pour assurer une régulation de la température à l'intérieur de la deuxième enceinte 41 à une température de consigne. Par exemple, la régulation en température est réalisée en alimentant électriquement les modules Peltier 61 et/ou en pilotant les ventilateurs 65 (marche / arrêt, vitesse de rotation).

Avantageusement, le système de protection 2 comporte au moins un capteur connecté au circuit de commande pour mesurer une ou plusieurs grandeurs environnementales à l'intérieur de la deuxième enceinte 41, tels qu'un ou plusieurs capteurs de température et/ou d'humidité et/ou de pression.

En variante, de tels capteurs peuvent aussi être placés à l'intérieur de la première enceinte 31.

La régulation de la température est alors assurée par le circuit de commande en fonction des grandeurs mesurées par ces capteurs, notamment en fonction des variations de la température interne de la deuxième enceinte 41, par exemple en fonction d'une ou de plusieurs lois de commandes prédéfinies, pour atteindre la température de consigne.

Par exemple, le circuit de commande comporte une interface de commande qui permet à un utilisateur de sélectionner une température de consigne et/ou d'être informé de la température qui règne à l'intérieur de la deuxième enceinte 41 et/ou, plus généralement, de recevoir des informations sur le fonctionnement du dispositif de refroidissement 6.

Par exemple, l'interface de commande comporte un écran d'affichage, et/ou un ou plusieurs témoins lumineux, et/ou un ou plusieurs boutons ou sélecteurs mécanique, et/ou un écran tactile, et/ou un ou plusieurs connecteurs ou interfaces radio pour piloter le circuit de commande depuis un appareil extérieur.

De préférence, l'interface de commande est placée dans le premier compartiment 3, notamment en façade du premier compartiment 3, par exemple montée sur la plaque 34.

Selon des modes de réalisation, comme illustré sur la figure 2, le système de protection 2 comporte un étage additionnel 7 fixé au deuxième compartiment 4, par exemple fixé sous le deuxième compartiment 4.

Par exemple, l'étage additionnel 7 est détachable du deuxième compartiment 4 auquel il est fixé.

Dans l'exemple illustré, le deuxième compartiment 4 et l'étage additionnel 7 sont attachés l'un à l'autre, de façon réversible, au moyen de dispositifs de fixation tels que des vis 83 ou des boulons.

Dans la configuration assemblée du système de protection 2, l'étage 7 est empilé sous les compartiments 3 et 4 le long de la direction verticale Z.

L'étage additionnel 7 délimite un volume de réception du radiateur extérieur 64. Le volume de réception est ici délimité par des parois latérales de l'étage additionnel 7 montées sur une paroi de fond de l'étage additionnel 7.

Par exemple, l'étage additionnel 7 présente une forme semblable à celle des compartiments 3 et 4.

L'étage additionnel 7 est avantageusement réalisé dans le même matériau que les compartiments 3 et 4.

Selon des exemples, l'étage additionnel 7 comporte au moins un ventilateur 71 pour évacuer la chaleur dégagée par le radiateur externe vers l'extérieur du boîtier.

Dans l'exemple illustré, l'étage additionnel 7 comporte plusieurs ventilateurs 71 disposés en rangées et reçus dans des ouvertures formées dans les parois latérales de l'étage additionnel 7.

Optionnellement, l'étage additionnel 7 peut comporter, en face avant, une plaque 72 similaire aux plaques 34 et 43 précédemment décrites.

Ainsi, en configuration assemblée, le radiateur extérieur 63 est reçu dans l'étage additionnel 7, de telle sorte que la chaleur dégagée par la face chaude des modules Peltier 61 lors du refroidissement de la deuxième enceinte 41 est conduite dans l'étage additionnel 7 par le radiateur extérieur 63 puis évacuée en dehors du boîtier du système de protection 2 par les ventilateurs 71.

De préférence, les ventilateurs 71 sont également pilotés par le circuit de commande afin d'assurer la régulation de température dans la deuxième enceinte 41.

Selon des modes de réalisation optionnels mais néanmoins avantageux, le premier compartiment 3 comporte en outre un dispositif de refroidissement auxiliaire 33 incluant un conduit de ventilation 332 intégré à l'intérieur du premier compartiment et longeant la première enceinte 31.

Dans l'exemple illustré, le premier compartiment 3 comporte en fait deux dispositifs de refroidissement auxiliaires 33, disposés sur deux côtés opposés du premier compartiment 3, mais seul l'un d'eux est décrit dans ce qui suit.

Par exemple, le conduit de ventilation 332 est intercalé entre la première enceinte 31 et une des parois latérales 32. Le conduit de ventilation 332 est séparé de la première enceinte par une cloison interne.

Le conduit de ventilation 332 est par exemple formé sur une partie supérieure du premier compartiment 3 et est recouvert par un capot 334.

Le conduit de ventilation 332 s'étend longitudinalement, ici d'avant en arrière, entre une entrée 333 disposée sur un côté du premier compartiment 3 et une sortie, ici débouchant en face arrière du premier compartiment 3.

Le dispositif de refroidissement auxiliaire 33 comporte en outre au moins un ventilateur 331 disposé dans le conduit de ventilation 332, par exemple placé en sortie du conduit de ventilation 332.

Le ventilateur 331 peut également être piloté par le circuit de commande du dispositif de refroidissement 6, ou, alternativement, être piloté par un circuit de commande dédié reçu dans le premier compartiment 3, afin d'assurer une régulation de la température à l'intérieur de la première enceinte 31 par exemple en fonction d'une température de consigne et éventuellement au moyen d'un ou plusieurs capteurs placés dans la première enceinte 31. Cette température de consigne n'est pas nécessairement la même que la température de consigne de la deuxième enceinte 41.

Ainsi, le dispositif de refroidissement auxiliaire 33 permet d'évacuer la chaleur dégagée par d'éventuels composants électroniques installés à l'intérieur de la première enceinte 31.

Un tel dispositif de refroidissement auxiliaire 33 est suffisant, puisque la première enceinte 31 n'est pas destinée à accueillir des composants électroniques nécessitant un refroidissement, ces derniers étant en priorité installés dans la deuxième enceinte 41.

Le dispositif de refroidissement auxiliaire 33 peut également comporter des ailettes ou cloisons verticales disposées dans et le long du conduit de ventilation 332, pour faciliter le refroidissement de la première enceinte 31.

De façon générale, grâce aux modes de réalisation décrits ci-dessus, le système de protection 2 présente un aspect modulaire et standardisé.

Cela permet notamment de ne pas devoir redimensionner la totalité du système en cas de remplacement d'un composant électronique 5, puisqu'il suffit alors de redimensionner le compartiment correspondant.

Ainsi, le premier compartiment peut servir d'interface standardisée avec d'autres équipements, notamment pour assurer la connexion et l'intégration de l'appareil électronique formé à partir des composants électroniques 5 montés dans le système de protection 2.

En particulier, le premier compartiment 3 contient le circuit de commande du dispositif de refroidissement 6 ainsi que l'interface de commande permettant de piloter ce dispositif de refroidissement, qui peuvent ainsi être réutilisés de façon standardisée lorsque le deuxième compartiment 4 est remplacé et ce quelle que soit la nature des composants électroniques 5 logés dans le deuxième compartiment 4.

Comme on l'aura compris, le boîtier protège mécaniquement les composants électroniques 5, notamment pour les protéger contre les chocs et les chutes, et pour assurer une étanchéité notamment contre l'humidité et/ou les corps étrangers.

Le boîtier peut également protéger les composants électroniques 5 contre des perturbations électromagnétiques, par exemple au moyen d'un blindage adéquat.

Grâce à la conception du système de protection 2, le dispositif de refroidissement 6 permet de refroidir seulement les composants électroniques 5 qui ont réellement besoin d'être refroidis, les autres composants électroniques jugés moins critiques à cet égard étant alors placés dans le premier compartiment.

Grâce à l'utilisation des modules Peltier 61, le dispositif de refroidissement 6 permet d'assurer une régulation efficace de la température, notamment pour refroidir l'intérieur de la deuxième enceinte 41, de façon plus simple à gérer et à entretenir qu'avec des groupes frigorifiques traditionnellement utilisés.

De façon avantageuse, les modules Peltier 61 peuvent aussi être utilisés pour chauffer l'intérieur de la deuxième enceinte 41, ce qui permet au système de protection 2 d'être adapté à toutes les circonstances sans avoir besoin de rajouter des éléments de chauffage additionnels, tels que des résistances électriques.

Les modes de réalisation et les variantes envisagés ci-dessus peuvent être combinés entre eux pour donner naissance à de nouveaux modes de réalisation.

## Revendications

1. Système de protection (2) pour un équipement électronique, dans lequel ce système comporte un boîtier comprenant un premier compartiment (3) et un deuxième compartiment (4), le premier compartiment (3) délimitant une première enceinte fermée (31), le deuxième compartiment délimitant une deuxième enceinte fermée (41) séparée de la première enceinte et apte à recevoir au moins un composant électronique, le deuxième compartiment (4) comprenant un système de refroidissement (6) incluant au moins un module Peltier (61) fixé sur le fond de la deuxième enceinte,
**caractérisé en ce que** le premier compartiment (3) est détachable du deuxième compartiment (4), et
**en ce que** ce système de protection (2) comporte un circuit de commande placé à l'intérieur du premier compartiment (3) et configuré pour piloter les modules Peltier (61) afin d'assurer une régulation de la température à l'intérieur de la deuxième enceinte (41) en fonction d'une température de consigne.

2. Système de protection selon la revendication 1, **caractérisé en ce que** les premier et deuxième compartiments (3, 4) sont isolés physiquement et thermiquement l'un de l'autre par une paroi de séparation.

3. Système de protection selon l'une quelconque des revendications précédentes, **caractérisé en ce que** le dispositif de refroidissement (6) comporte également un radiateur externe (64) connecté aux modules Peltier (61).

4. Système de protection selon la revendication 3, **caractérisé en ce que** le système de protection (2) comporte un étage additionnel (7) connecté au deuxième compartiment (4) et qui délimite un volume de réception du radiateur extérieur, l'étage additionnel comportant au moins un ventilateur (71) pour évacuer la chaleur dégagée par le radiateur externe vers l'extérieur du boîtier.

5. Système de protection selon la revendication 3 ou la revendication 4, **caractérisé en ce que** les modules Peltier (61) sont directement montés sur une feuille (62) d'un matériau thermiquement conducteur, notamment une feuille de graphite, placée sur le radiateur externe (64).

6. Système de protection selon l'une quelconque des revendications précédentes, **caractérisé en ce que** les parois (42) internes de la deuxième enceinte sont au moins en partie recouvertes d'un matériau thermiquement isolant (44).

7. Système de protection selon l'une quelconque des revendications précédentes, **caractérisé en ce que** le dispositif de refroidissement (6) comporte un radiateur interne (63) monté sur les modules Peltier (61) et disposé à l'intérieur de la deuxième enceinte (41).

8. Système de protection selon l'une quelconque des revendications précédentes, **caractérisé en ce qu'**au moins un composant électronique (5) est installé à l'intérieur du deuxième compartiment (4).

9. Système de protection selon l'une quelconque des revendications précédentes, **caractérisé en ce que** le premier compartiment (3) comporte un dispositif de refroidissement auxiliaire (33) incluant un conduit de ventilation (332) dans lequel est placé au moins un ventilateur (331), le conduit de ventilation étant intégré à l'intérieur du premier compartiment et longeant la première enceinte (31).

10. Système de protection selon l'une quelconque des revendications précédentes, **caractérisé en ce qu'**il comporte au moins un capteur connecté au circuit de commande pour mesurer une ou plusieurs grandeurs environnementales à l'intérieur de la deuxième enceinte (41), tels qu'un ou plusieurs capteurs de température et/ou d'humidité et/ou de pression.

11. Système de protection selon l'une quelconque des revendications précédentes, **caractérisé en ce que** le circuit de commande est également configuré pour piloter un ou plusieurs ventilateurs pour assurer la régulation de température.

## Patentansprüche

1. Schutzsystem (2) für eine elektronische Ausrüstung, wobei dieses System ein Gehäuse umfasst, das ein erstes Fach (3) und ein zweites Fach (4) umfasst, wobei das erste Fach (3) eine erste geschlossene Kammer (31) begrenzt, das zweite Fach eine zweite geschlossene Kammer (41) begrenzt, die von der ersten Kammer getrennt ist, und geeignet ist, um mindestens ein elektronisches Bauteil aufzunehmen, das zweite Fach (4) umfassend ein Kühlsystem (6), das mindestens ein Peltier-Modul (61) beinhaltet, das an dem Boden der zweiten Kammer befestigt ist, **dadurch gekennzeichnet, dass** das erste Fach (3) von dem zweiten Fach (4) abnehmbar ist, und
dass dieses Schutzsystem (2) eine Steuerschaltung umfasst, die im Inneren des ersten Fachs (3) platziert und konfiguriert ist, um die Peltier-Module (61) zu steuern, um eine Regulierung der Temperatur im Inneren der zweiten Kammer (41) abhängig von einer Vorgabetemperatur zu gewährleisten.

2. Schutzsystem nach Anspruch 1, **dadurch gekennzeichnet, dass** das erste und das zweite Fach (3, 4) durch eine Trennwand physisch und thermisch voneinander isoliert sind.

3. Schutzsystem nach einem der vorherigen Ansprüche, **dadurch gekennzeichnet, dass** die Kühlvorrichtung (6) auch einen externen Kühler (64) umfasst, der mit den Peltier-Modulen (61) verbunden ist.

4. Schutzsystem nach Anspruch 3, **dadurch gekennzeichnet, dass** das Schutzsystem (2) eine zusätzliche Stufe (7) umfasst, die mit dem zweiten Fach (4) verbunden ist und die ein Aufnahmevolumen des externen Kühlers begrenzt, wobei die zusätzliche Stufe mindestens einen Lüfter (71) zum Abführen der von dem externen Kühler abgegebenen Wärme zur Außenseite des Gehäuses umfasst.

5. Schutzsystem nach Anspruch 3 oder 4, **dadurch gekennzeichnet, dass** die Peltier-Module (61) direkt auf eine Folie (62) aus einem wärmeleitenden Material, insbesondere einer Graphitfolie, montiert sind, die auf dem äußeren Kühler (64) platziert ist, montiert sind.

6. Schutzsystem nach einem der vorherigen Ansprüche, **dadurch gekennzeichnet, dass** die Innenwände (42) der zweiten Kammer zumindest teilweise mit einem wärmeisolierenden Material (44) bedeckt sind.

7. Schutzsystem nach einem der vorherigen Ansprüche, **dadurch gekennzeichnet, dass** die Kühlvorrichtung (6) einen internen Kühler (63) umfasst, der an den Peltier-Modulen (61) montiert und innerhalb der zweiten Kammer (41) angeordnet ist.

8. Schutzsystem nach einem der vorherigen Ansprüche, **dadurch gekennzeichnet, dass** mindestens ein elektronisches Bauteil (5) im Inneren des zweiten Fachs (4) installiert ist.

9. Schutzsystem nach einem der vorherigen Ansprüche, **dadurch gekennzeichnet, dass** das erste Fach (3) eine Hilfskühlvorrichtung (33) umfasst, die einen Lüftungskanal (332) einschließt, in den mindestens ein Ventilator (331) platziert ist, wobei der Ventilationskanal in das Innere des ersten Fachs integriert ist und entlang der ersten Kammer (31) verläuft.

10. Schutzsystem nach einem der vorherigen Ansprüche, **dadurch gekennzeichnet, dass** es mindestens einen Sensor umfasst, der mit der Steuerschaltung verbunden ist, um eine oder mehrere Umgebungsgrößen im Inneren der zweiten Kammer (41) zu messen, wie beispielsweise einen oder mehrere Temperatur- und/oder Feuchtigkeits- und/oder Drucksensoren.

11. Schutzsystem nach einem der vorherigen Ansprüche, **dadurch gekennzeichnet, dass** die Steuerschaltung auch konfiguriert ist, um einen oder mehrere Lüfter anzusteuern, um die Temperaturregulierung zu gewährleisten.

## Claims

1. A protection system (2) for a piece of electronic equipment, **characterized in that** this system includes a housing comprising a first compartment (3) and a second compartment (4), the first compartment (3) delimiting a first closed chamber (31), the second compartment delimiting a second closed chamber (41) separated from the first chamber and able to receive at least one electronic component, the second compartment (4) comprising a cooling system (6) including at least one Peltier module (61) attached on the bottom of the second chamber,
**characterized in that** the first compartment (3) is detachable from the second compartment (4), and
**in that** the protection system (2) includes a control circuit placed inside the first compartment (3) and configured to steer the Peltier modules (61) in order to ensure regulation of the temperature inside the second chamber (41) as a function of a setpoint temperature.

2. The protection system according to claim 1, **characterized in that** the first and second compartments (3, 4) are physically and thermally isolated from one another by a separating wall.

3. The protection system according to any one of the preceding claims, **characterized in that** the cooling device (6) also includes an external radiator (64) connected to the Peltier modules (61).

4. The protection system according to claim 3, **characterized in that** the protection system (2) includes an additional stage (7) connected to the second compartment (4) and which delimits a receiving volume of the external radiator, the additional stage including at least one fan (71) for discharging the heat given off by the external radiator toward the outside of the housing.

5. The protection system according to claim 3 or claim 4, **characterized in that** the Peltier modules (61) are directly mounted on a sheet (62) of a thermally conductive material, in particular a sheet of graphite, placed under the external radiator (64).

6. The protection system according to any one of the preceding claims, **characterized in that** the inner walls (42) of the second chamber are at least partially covered with a thermally insulating material (44).

7. The protection system according to any one of the preceding claims, **characterized in that** the cooling device (6) includes an internal radiator (63) mounted on the Peltier modules (61) and arranged inside the second chamber (41).

8. The protection system according to any one of the preceding claims, **characterized in that** at least one electronic component (5) is installed inside the second compartment (4).

9. The protection system according to any one of the preceding claims, **characterized in that** the first compartment (3) includes an auxiliary cooling device (33) including a ventilation duct (332) in which at least one fan (331) is placed, the ventilation duct being integrated inside the first compartment and running along the first chamber (31).

10. The protection system according to any one of the preceding claims, **characterized in that** it includes at least one sensor connected to the control circuit in order to measure one or several environmental properties inside the second chamber (41), such as one or several temperature and/or humidity and/or pressure sensors.

11. The protection system according to any one of the preceding claims, **characterized in that** the control circuit is also configured to steer one or several fans to ensure the temperature regulation.
